# EUROPÄISCHE PATENTSCHRIFT

(11) **EP 2 799 946 B1**
(45) Veröffentlichungstag und Bekanntmachung des Hinweises auf die Patenterteilung: **05.10.2016**
(21) Anmeldenummer: 13166484.9
(22) Anmeldetag: 03.05.2013
(51) Int. Cl.: G05B 19/042, G01R 31/02

(54) **Verfahren zur Kompatibilitätsherstellung zwischen einem Feldgerät und einer Diagnoseeinrichtung und Interfacegerät**
Method for establishing compatibility between a field device and a diagnostic device and interface device
Procédé de réalisation d'une compatibilité entre d'un appareil de terrain et un dispositif de diagnostique et dispositif d'interface

(43) Veröffentlichungstag der Anmeldung: 05.11.2014
(73) Patentinhaber: Pepperl + Fuchs GmbH, 68307 Mannheim (DE)
(72) Erfinder: Jung, Martin, 67240 Bobenheim - Roxheim (DE); Ball, Peter, 68199 Mannheim (DE)
(74) Vertreter: Schiffer, Axel Martin

(56) Entgegenhaltungen:
- EP-A2- 1 403 745
- DE-A1-102006 020 070
- DE-A1-102010 044 186
- DE-A1-102011 075 764
- US-A1- 2002 167 904

## Beschreibung

Die vorliegende Erfindung betrifft ein Interfacegerät zum Verbinden eines Leitsystems mit einem Feldgerät oder mit einem anderen Interfacegerät eines Feldgeräts, wobei das Interfacegerät eine Schaltungsanordnung zur Kompatibilitätsherstellung zwischen dem Feldgerät oder dessen Interfacegerät und einer Diagnoseeinrichtung eines Leitsystems, an dessen Ausgang das Interface- oder Feldgerät anschließbar ist, aufweist, nach dem Oberbegriff des Anspruchs 2. Zudem betrifft die Erfindung ein entsprechendes Verfahren zur Kompatibilitätsherstellung nach dem Oberbegriff des Anspruchs 1.

Das Leitsystem kann beispielsweise eine speicherprogrammierbare Steuerung (SPS) sein. Diese nutzt eine Diagnoseeinrichtung zur Überwachung des Steuerungskreises, das heißt angeschlossener Geräte. Insbesondere bei Anwendungen der Sicherheitsanforderungsstufe 3 (SIL3) werden Diagnosefunktionen eingesetzt.

Bei einer gattungsgemäßen Schaltungsanordnung ist die Diagnoseeinrichtung dazu eingerichtet, über den Ausgang des Leitsystems ein Testsignal an das Interface- oder Feldgerät zu geben und ein Fehlersignal auszugeben, wenn eine elektrische Antwort am Ausgang des Leitsystems außerhalb eines Erwartungsbereichs liegt. Dabei weist die Schaltungsanordnung Spannungsbeeinflussungsmittel zum Beeinflussen einer Spannung am Ausgang des Leitsystems auf.

Das Testsignal kann beispielsweise eine Änderung der Spannungsausgabe am Ausgang oder auch einen Strompuls umfassen. Ein angeschlossenes Feldgerät kann eine elektrische Antwort bewirken, also insbesondere eine Spannungsantwort oder auch eine Stromantwort. Darunter ist zu verstehen, dass die Spannung am Ausgang oder ein Strom zwischen den beiden elektrischen Anschlüssen des Ausgangs durch das Feldgerät beeinflusst wird. Die Diagnoseeinrichtung überprüft, ob diese Antwort innerhalb eines Erwartungsbereichs liegt, das heißt eines Spannungserwartungsbereichs und/oder eines Stromerwartungsbereichs. Zusätzlich kann gefordert sein, dass der Erwartungsbereich innerhalb einer vorgegebenen Zeitdauer nach dem Beginn des Testsignals erreicht wird.

Bei einem gattungsgemäßen Verfahren zur Kompatibilitätsherstellung zwischen einem Feldgerät oder einem Interfacegerät für ein Feldgerät und einer Diagnoseeinrichtung eines Leitsystems gibt die Diagnoseeinrichtung über den Ausgang des Leitsystems ein Testsignal an das Interface- oder Feldgerät und gibt ein Fehlersignal aus, wenn eine elektrische Antwort am Ausgang des Leitsystems außerhalb eines Erwartungsbereichs liegt, wobei mit Spannungsbeeinflussungsmitteln eine Spannung am Ausgang des Leitsystems beeinflusst wird.

Bei dem Feldgerät kann es sich beispielsweise um eine elektrische Last oder eine verhältnismäßig einfache elektrische Komponente handeln. Hierzu zählen unter anderem Ventile oder Relais. Diese einfachen Lasten geben eine Spannungsantwort an den Ausgang des Leitsystems, welche von üblichen Diagnoseeinrichtungen korrekt interpretiert werden kann. Daher können die Diagnoseeinrichtungen bei diesen einfachen Lasten zutreffend ein Fehlersignal ausgeben, wenn das angeschlossene Feldgerät nicht zulässig oder nicht funktionstüchtig ist.

Oftmals werden aber auch komplexere Feldgeräte oder auch Interfacegeräte an den Ausgang des Leitsystems angeschlossen. Ein Interfacegerät dient dem Verbinden des Leitsystems mit einem Feldgerät. Dabei kann es sich beispielsweise um einen Ventiltreiber handeln. Insbesondere bei solchen Interface- oder Feldgeräten schlägt ein Test üblicher Diagnoseeinrichtungen oftmals fehl.

Um dennoch solche Interface- oder Feldgeräte mit dem Leitsystem verwenden zu können, wird herkömmlicherweise oftmals die Diagnoseeinrichtung deaktiviert. Daran ist nachteilig, dass auf die Sicherheitsmaßnahmen des Leitsystems verzichtet wird.

Daher ist es wünschenswert, eine Kompatibilität zwischen möglichst beliebigen Interface- oder Feldgeräten und dem Test der Diagnoseeinrichtung herzustellen.

Zur Kompatibilitätsherstellung sind bei bekannten Schaltungsanordnungen die vorgenannten Spannungsbeeinflussungsmittel vorhanden, welche eine Spannung am Ausgang des Leitsystems beeinflussen.

Die Spannungsbeeinflussungsmittel können im Stand der Technik beispielsweise einen Schaltungszweig umfassen, der am Ausgang des Leitsystems parallel zu einem anschließbaren Interface- oder Feldgerät verläuft. In diesem Schaltungszweig wird eine niederohmige Last eingefügt. Dies kann bei bestimmten statischen Tests der Diagnoseeinrichtung eine Kompatibilität herstellen. Bei einem statischen Test wird die Spannungsantwort am Ausgang des Leitsystems ausgewertet, die auf das Testsignal folgt. Dabei bleibt die Zeitdauer unberücksichtigt, die erforderlich ist, bis sich die Spannungsantwort einstellt. Beispielsweise wird als Testsignal ein Teststrom ausgegeben, dessen Höhe vorgegeben ist. Die Diagnoseeinrichtung untersucht sodann, ob ein Spannungsabfall, der durch den Teststrom erzeugt wird, in einem vorgegebenen Erwartungsbereich liegt.

Die oben genannte niederohmige Last kann den Teststrom der Diagnoseeinrichtung führen, wenn das angeschlossene Interface- oder Feldgerät ausgeschaltet ist. Dadurch kann in diesem ausgeschalteten Zustand eine Spannungsantwort erzeugt werden, die innerhalb des Erwartungsbereichs der Diagnoseeinrichtung liegt. Dadurch wird vermieden, dass ein Fehlersignal erzeugt wird. Je niederohmiger jedoch die Last ist, desto höher sind die Energieverluste im angeschalteten Zustand des Interface- oder Feldgeräts. Dadurch kann der Widerstandswert der Last nicht beliebig klein gewählt werden. Erwartet die Diagnoseeinrichtung eine sehr niederohmige Last, kann daher keine Kompatibilität hergestellt werden. Somit können solche Spannungsbeeinflussungsmittel nur zu wenigen Diagnoseeinrichtungen eine Kompatibilität herstellen.

Bekannt ist außerdem, als Spannungsbeeinflussungsmittel eine Schaltung zum Entladen der Leitungskapazität an den Ausgang des Leitsystems anzuschließen. Eine solche Schaltung ist geeignet, um eine Kompatibilität zu bestimmten dynamischen Tests einiger Diagnoseeinrichtungen herzustellen. Bei dynamischen Tests wird der zeitliche Verlauf der Spannungsantwort berücksichtigt. Die vorgenannte Schaltung entlädt die Kapazität der Leitung am Ausgang, wenn das Interface- oder Feldgerät ausgeschaltet wird. Hierzu kann der Ausgang über einen Widerstand von beispielsweise 500 Ohm kurzgeschlossen werden. Dadurch fällt der Spannungspegel am Ausgang schnell ab und kann nach einer kurzen Zeitdauer innerhalb des Spannungserwartungsbereichs liegen. Somit vermeidet die Schaltung, dass in diesem Fall fälschlicherweise ein Fehlersignal ausgegeben wird. Da der genannte Widerstand aber nicht beliebig klein sein kann, kann die Entladung der Leitungskapazität nicht beliebig schnell erfolgen. Für manche dynamischen Tests wird daher die Leitungskapazität nicht rechtzeitig entladen. Es kann auch vorkommen, dass der Spannungsabfall, der mit dem Widerstand erzeugt wird, zu einer Spannung außerhalb des Spannungserwartungsbereichs führt. Daher wird nur eine Kompatibilität zu bestimmten dynamischen Tests von Diagnoseeinrichtungen erreicht. Zudem wird in der Regel in dieser Weise keine Kompatibilität zu statischen Tests bereitgestellt.

Manche Diagnoseeinrichtungen geben ein Fehlersignal bereits dann aus, wenn ein Spannungsabfall im ausgeschalteten Zustand des Interface- oder Feldgeräts 0,6 V überschreitet. In diesem Fall können bereits Gleichrichter, Verpolschutzdioden oder andere PN-Übergänge, die an den Ausgang des Leitsystems angeschlossen werden, zu einer Fehlermeldung führen. Insbesondere in diesen Fällen sind die oben beschriebenen Spannungsbeeinflussungsmittel nicht geeignet.

Auch wenn die beiden Spannungsbeeinflussungsmittel, die zu den statischen Tests und den dynamischen Tests beschrieben wurden, kombiniert werden, kann nur zu verhältnismäßig wenigen Tests von Diagnoseeinrichtungen eine Kompatibilität erreicht werden.

In DE 10 2010 044 186 A1 ist ein Leitsystem mit Feldgeräten und einer Kommunikationseinheit beschrieben, welche Diagnosemeldungen der Feldgeräte empfängt und daraufhin umgewandelte Diagnosemeldungen ausgibt.

Aus US 2002/0167904 A1 ist ein Kommunikations- und Diagnosegerät bekannt, welches erkennt, an was für ein Gerät oder Schaltkreis es angeschlossen ist und daraufhin eine hierfür geeignete Kommunikation wählt.

Als eine **Aufgabe** der Erfindung kann erachtet werden, ein Interfacegerät und ein Verfahren anzugeben, mit denen eine Kompatibilitätsherstellung zwischen einem Feldgerät oder einem Interfacegerät und möglichst zahlreichen verschiedenen Diagnoseeinrichtungen eines Leitsystems ermöglicht wird.

Diese Aufgabe wird durch das Interfacegerät mit den Merkmalen des Anspruchs 2 und durch das Verfahren mit den Merkmalen des Anspruchs 1 gelöst.

Vorteilhafte Varianten des erfindungsgemäßen Interfacegeräts mit der Schaltungsanordnung und des erfindungsgemäßen Verfahrens sind Gegenstand der abhängigen Ansprüche und werden außerdem in der folgenden Beschreibung erläutert.

Bei der Schaltungsanordnung der oben genannten Art ist erfindungsgemäß vorgesehen, dass die Spannungsbeeinflussungsmittel eine ansteuerbare Stromquelle aufweisen, mit der ein Strom erzeugbar ist zum Beeinflussen einer Spannung am Ausgang des Leitsystems, dass elektronische Analyse- und Steuermittel vorhanden und dazu eingerichtet sind, ein Testsignal am Ausgang des Leitsystems zu identifizieren und bei einer Identifizierung eines Testsignals die ansteuerbare Stromquelle zum Einstellen einer Sollspannung am Ausgang des Leitsystems anzusteuern, wobei die Sollspannung innerhalb des Erwartungsbereichs liegt.

Bei dem Verfahren der oben beschriebenen Art ist gemäß der Erfindung vorgesehen, dass die Spannungsbeeinflussungsmittel eine ansteuerbare Stromquelle aufweisen, dass ein Testsignal am Ausgang des Leitsystems von elektronischen Analyse- und Steuermitteln identifiziert wird, dass bei einer Identifizierung eines Testsignals die ansteuerbare Stromquelle von den Analyse- und Steuermitteln dazu angesteuert wird, eine Sollspannung am Ausgang des Leitsystems einzustellen, wobei die Sollspannung innerhalb des Erwartungsbereichs liegt.

Als ein Kerngedanke der Erfindung kann angesehen werden, ein Testsignal der Diagnoseeinrichtung zu messen und die Spannungsbeeinflussungsmittel abhängig davon anzusteuern, ob ein Testsignal erkannt worden ist. Vorteilhafterweise können somit verschiedene Testsignale unterschieden werden. Für jedes Testsignal kann eine geeignete Spannung am Ausgang des Leitsystems eingestellt werden. Dadurch kann für zahlreiche verschiedene Testsignale vermieden werden, dass ein Fehlersignal fälschlicherweise ausgegeben wird.

Gemäß der Erfindung wird hierzu eine ansteuerbare Stromquelle eingesetzt. Diese kann einen Strom erzeugen, der zwischen den beiden Leitungsanschlüssen des Ausgangs des Leitsystems fließt. Dadurch wird die Spannung am Ausgang verändert. Weil eine Größe des Stroms, der von der Stromquelle bereitgestellt wird, variabel vorgegeben werden kann, wird vorteilhafterweise eine variable Beeinflussung der Spannung am Ausgang ermöglicht.

Um die Spannung für die vorhandene Diagnoseeinrichtung geeignet zu beeinflussen, ist es essentiell, dass zunächst die Analyse- und Steuermittel das Testsignal der Diagnoseeinrichtung identifizieren.

Bei dem Testsignal kann es sich prinzipiell um eine beliebige Spannungs- und/oder Stromänderung handeln. Auch der zeitliche Verlauf dieser Spannungs- und/oder Stromänderung kann berücksichtigt werden, um ein Testsignal zu erkennen.

Zum Identifizieren eines Testsignals können daher die elektronischen Analyse- und Steuermittel bevorzugt eine Messung einer Spannung und/oder eines Stroms am

Ausgang des Leitsystems durchführen. Dabei kann auch der zeitliche Verlauf der Spannung und/oder des Stroms erfasst werden.

Die elektronischen Analyse- und Steuermittel können dazu eingerichtet sein, ein Testsignal zu identifizieren basierend auf einer Messung einer Stromstärke, einer Stromstärkenänderung, einer Spannungshöhe und/oder einer Spannungshöhenänderung am Ausgang des Leitsystems. Im Vergleich zu herkömmlichen Spannungsbeeinflussungsmitteln wird dadurch eine Spannung am Ausgang des Leitsystems jedenfalls dann nicht beeinflusst, wenn kein Test durchgeführt wird.

Mit den elektronischen Analyse- und Steuermitteln kann ein Ergebnis der Messung mit vorgegebenen Kriterien bewertbar sein, um zwischen verschiedenen Arten von Testsignalen zu unterscheiden. Die Kriterien können Höhen oder Änderungen der Spannung und/oder des Stroms sowie einen zeitlichen Verlauf von diesem umfassen. Diese Ausführung nutzt die Erkenntnis, dass bei verschiedenen Tests von Diagnoseeinrichtungen nicht bloß die Spannungserwartungsbereiche unterschiedlich sind, sondern auch verschiedene Testsignale ausgegeben werden, die mit bestimmten Kriterien unterschieden werden können.

Die elektronischen Analyse- und Steuermittel können in einem nicht flüchtigen Speicher eine Liste enthalten, in welcher verschiedene Kriterien aufgeführt sind. Für jedes Kriterium ist hinterlegt, wie die Stromquelle anzusteuern ist.

Es ist besonders bevorzugt, wenn die elektronischen Analyse- und Steuermittel dazu eingerichtet sind, für verschiedene Arten von Testsignalen eine Höhe und/oder Dauer eines von der Stromquelle erzeugten Stroms unterschiedlich einzustellen. Dadurch ist es möglich, zwischen verschiedenen Spannungswerten am Ausgang des Leitsystems zu wählen. Insbesondere abhängig von den zuvor genannten Kriterien kann daher die Stromquelle in verschiedener Weise angesteuert werden.

Damit eine Kompatibilität zu besonders vielen verschiedenen Diagnoseeinrichtungen hergestellt werden kann, sind die elektronischen Analyse- und Steuermittel bevorzugt dazu eingerichtet, mit den vorgegebenen Kriterien mehrere gleichzeitige Testsignale unterschiedlicher Art erkennen zu können und die Stromquelle abhängig von gleichzeitig erkannten Testsignalen anzusteuern. Beispielsweise kann so ein Strom- und/oder Spannungsverlauf am Ausgang des Leitsystems eingestellt werden, für den sowohl bei statischen als auch dynamischen Tests kein Fehlersignal ausgegeben wird.

Besonders bevorzugt sind die Kriterien der elektronischen Analyse- und Steuermittel, mit denen ein Testsignal identifiziert wird, variabel einstellbar. Dadurch kann die Schaltungsanordnung der Erfindung auch für zukünftige Tests eingesetzt werden. Zudem ist es möglich, Kriterien zu verfeinern, falls erforderlich.

Hierzu können die elektronischen Analyse- Steuermittel einen Mikrocontroller aufweisen, mit dem Kriterien zum Identifizieren eines Testsignals variabel einstellbar sind. Weiterhin kann mit dem Mikrocontroller eine Höhe und/oder Dauer eines von der Stromquelle erzeugten Stroms variabel einstellbar sein. Dadurch wird die Flexibilität weiter gesteigert. Die Schaltungsanordnung kann Verbindungsanschlüsse aufweisen, an die ein Eingabemittel anschließbar ist, womit ein Benutzer neue Kriterien dem Mikrocontroller vorgeben kann. Das Eingabemittel kann beispielsweise ein Computer sein, der eine Funkverbindung oder eine kabelgebundene Verbindung zur Schaltungsanordnung herstellt.

Anstelle eines Mikrocontrollers kann die Schaltungsanordnung aber auch mit diskreten Bauteilen gebildet sein. Hierdurch können Herstellungskosten und unter Umständen Fehleranfälligkeiten reduziert werden.

Manche Interface- und Feldgeräte werden von der Diagnoseeinrichtung zutreffend erkannt, wenn sie eingeschaltet sind, nicht aber, wenn sie ausgeschaltet sind. Insbesondere für diesen Fall sind die elektronischen Analyse- und Steuermittel dazu eingerichtet, einen ausgeschalteten Zustand eines angeschlossenen Interface- oder Feldgeräts zu identifizieren und die ansteuerbare Stromquelle zum Einstellen der Sollspannung und/oder zum Erzeugen eines Stroms vorgegebener Höhe anzusteuern, wenn ein ausgeschalteter Zustand eines angeschlossenen Interface- oder Feldgeräts identifiziert wird. Die Stromquelle wird hier also nicht immer angesteuert, wenn ein Testsignal identifiziert wird, sondern nur, wenn zusätzlich das Interface- oder Feldgerät ausgeschaltet ist. Es kann auch vorgesehen sein, dass abhängig von der Art eines identifizierten Testsignals zusätzlich ein ausgeschalteter Zustand eines angeschlossenen Interface- oder Feldgeräts vorliegen muss, damit die Stromquelle angesteuert wird.

Die Energieversorgung der elektronischen Analyse- und Steuermittel kann prinzipiell in beliebiger Weise erfolgen. Insbesondere kann ein Kabelanschluss zur Energieversorgung oder eine Batterie vorhanden sein. Bevorzugt sind die elektronischen Analyse- und Steuermittel aber dazu eingerichtet, ihren Energiebedarf zum Steuern der ansteuerbaren Stromquelle aus der Spannung zu decken, die vom Leitsystem an ihrem Ausgang ausgegeben wird. Insbesondere können auch Strompulse von Testsignalen zur Energieversorgung eingesetzt werden. Es kann auch ein Speicher vorgesehen sein, der über den Ausgang des Leitsystems aufladbar ist. Als Speicher kann beispielsweise ein Kondensator, ein Superkondensator oder ein elektrochemischer Akkumulator eingesetzt werden.

Die Schaltungsanordnung kann prinzipiell Bestandteil einer beliebigen Vorrichtung sein, solange sie zwischen einer Diagnoseeinrichtung eines Leitsystems und einem zu überwachenden Feldgerät angeordnet ist oder anordenbar ist. So kann die Schaltungsanordnung beispielsweise starr mit dem Leitsystem oder mit einem Feldgerät verbunden sein.

Bevorzugt ist die Schaltungsanordnung aber eine vom Leitsystem und von Feldgeräten unabhängige Komponente, die zwischen diese angeschlossen werden kann. Zu diesem Zweck betrifft die Erfindung auch ein Interfacegerät zum Verbinden eines Feldgeräts mit einem Leitsystem, wobei das Interfacegerät erste Anschlussmittel zum Herstellen einer elektrischen Verbindung mit einem Leitsystem und zweite Anschlussmittel zum Herstellen einer elektrischen Verbindung mit einem Feldgerät aufweist. Dabei umfasst das Interfacegerät zusätzlich eine erfindungsgemäße Schaltungsanordnung. Grundsätzlich kann mit diesem Interfacegerät anstelle eines Feldgeräts auch eines der oben beschriebenen herkömmlichen Interfacegeräte verbunden werden, beispielsweise ein Ventiltreiber.

Weitere Vorteile und Merkmale der Erfindung werden nachstehend mit Bezug auf die beigefügten schematischen Figuren beschrieben. Hierin zeigen:
- Fig. 1: ein Leitsystem und eine herkömmliche Schaltungsanordnung;
- Fig. 2: ein Leitsystem und eine weitere herkömmliche Schaltungsanordnung;

- Fig. 3: ein Leitsystem und ein Ausführungsbeispiel einer erfindungsgemäßen Schaltungsanordnung;
- Fig. 4: eine Diagnosefunktion eines Leitsystems und
- Fig. 5: eine weitere Diagnosefunktion eines Leitsystems.

Gleiche und gleich wirkende Bestandteile sind in den Figuren in der Regel mit denselben Bezugszeichen gekennzeichnet.

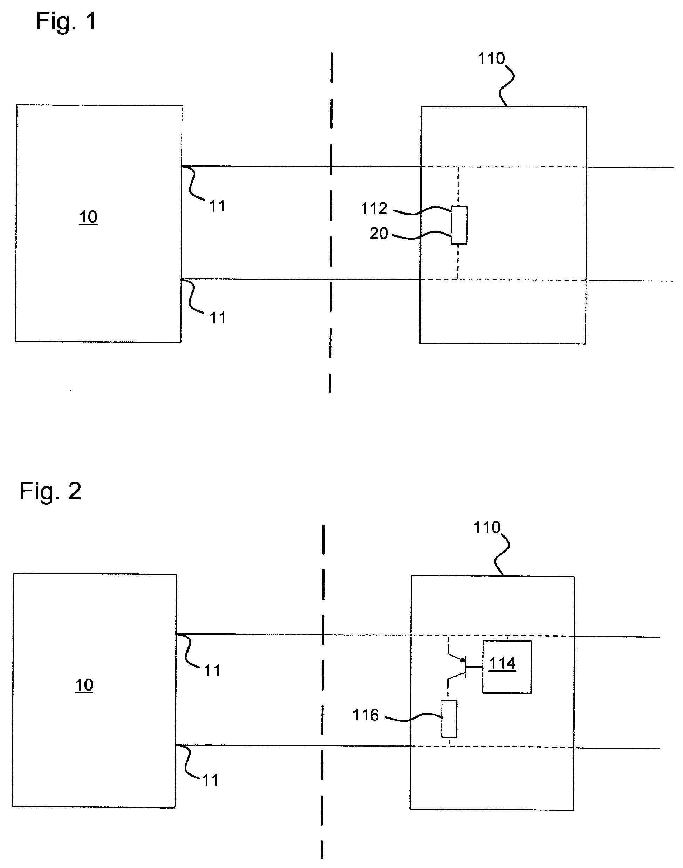

Fig. 1 zeigt schematisch ein Leitsystem 10 und eine daran angeschlossene herkömmliche Schaltungsanordnung 110.

Das Leitsystem 10 kann auch als Prozessleitsystem (PCS, Englisch: Process Control System) bezeichnet werden. Es umfasst einen Ausgang 11, der hier durch zwei elektrische Steckverbindungen 11 gebildet ist. Daran kann ein Feldgerät angeschlossen werden. Unter einem Feldgerät kann eine beliebige elektrische Vorrichtung verstanden werden, die Signale an das Leitsystem senden oder Signale von dem Leitsystem empfangen kann oder dessen Energieversorgung über den Ausgang des Leitsystems erfolgt. An den Ausgang 11 können auch ein Interfacegerät und/oder eine Schaltungsanordnung zwischengeschaltet werden, worauf das Feldgerät folgt.

Um die Anwesenheit, Kompatibilität oder Funktionstüchtigkeit eines angeschlossenen Feldgeräts festzustellen, weist das Leitsystem außerdem eine Diagnoseeinrichtung auf (nicht dargestellt). Die Diagnoseeinrichtung gibt ein elektrisches Testsignal am Ausgang 11 aus. Zudem misst sie eine elektrische Antwort am Ausgang 11, das heißt die Spannung und/oder den Strom am Ausgang 11. Diese Antwort hängt vom angeschlossenen Feldgerät ab und gibt daher eine Auskunft über dieses. Liegt eine Spannungsantwort am Ausgang des Leitsystems außerhalb eines Spannungserwartungsbereichs oder liegt eine Stromantwort außerhalb eines Stromerwartungsbereichs, so gibt die Diagnoseeinrichtung ein Fehlersignal aus. Damit wird angezeigt, dass kein ordnungsgemäßes Feldgerät angeschlossen ist.

Bei komplexeren Feldgeräten oder Interfacegeräten liegt die Spannungs- und/oder Stromantwort in manchen Fällen jedoch außerhalb des Erwartungsbereichs, obwohl das Gerät funktionstüchtig ist.

Aus diesem Grund kann eine zusätzliche Schaltungsanordnung am Ausgang des Leitsystems eingesetzt werden. Die Schaltungsanordnung weist Spannungsbeeinflussungsmittel auf, welche auf ein Testsignal hin eine Spannung und/oder einen Strom am Ausgang 11 so beeinflussen, dass Strom und/oder Spannung innerhalb des Erwartungsbereichs liegen. Damit wird verhindert, dass ein Fehlersignal fälschlicherweise ausgegeben wird.

In Fig. 1 ist eine herkömmliche Schaltungsanordnung 110 an den Ausgang 11 angeschlossen. Diese Schaltungsanordnung 110 weist als Spannungsbeeinflussungsmittel 20 einen Widerstand 112 auf. Dieser ist am Ausgang 11 parallel zu einem anschließbaren Feldgerät angeordnet.

Im ausgeschalteten Zustand eines Feldgerätes, das parallel zum Widerstand 112 angeschlossen ist, kann ein Testsignal oder Teststrom über den Widerstand 112 laufen. Um große Energieverluste zu vermeiden, wenn das Feldgerät eingeschaltet ist, darf der Widerstand 112 aber nicht beliebig klein gewählt werden. Dadurch kann der Widerstand 112 aber nicht eine Spannungs- und/oder Stromantwort erzeugen, die von einer Diagnoseeinrichtung gefordert wird, welche eine sehr niederohmige Last erwartet.

Ein Leitsystem 10 mit einer weiteren herkömmlichen Schaltungsanordnung 110 ist schematisch in Fig. 2 dargestellt. Diese Schaltungsanordnung 110 umfasst eine Steuerung 114. Über die Basis eines Transistors kann die Steuerung 114 einen Kurzschluss am Ausgang 11 bewirken, indem ein Widerstand 116 von beispielsweise 500 Ohm an den beiden Anschlüssen des Ausgangs 11 genutzt wird. Dadurch kann die elektrische Ladung des Testpulses schnell über den Widerstand 116 abfließen und der Spannungspegel am Ausgang 11 fällt schnell ab. Dadurch kann eine Kompatibilität zu bestimmten dynamischen Tests hergestellt werden. Es wird hiermit jedoch keine Kompatibilität zu sämtlichen dynamischen Tests und auch nicht zu statischen Tests erreicht.

Auch eine Schaltungsanordnung, welche die Komponenten der Schaltungsanordnungen 110 der Figuren 1 und 2 vereint, kann bloß eine Kompatibilität zu verhältnismäßig wenigen statischen und dynamischen Tests bereitstellen.

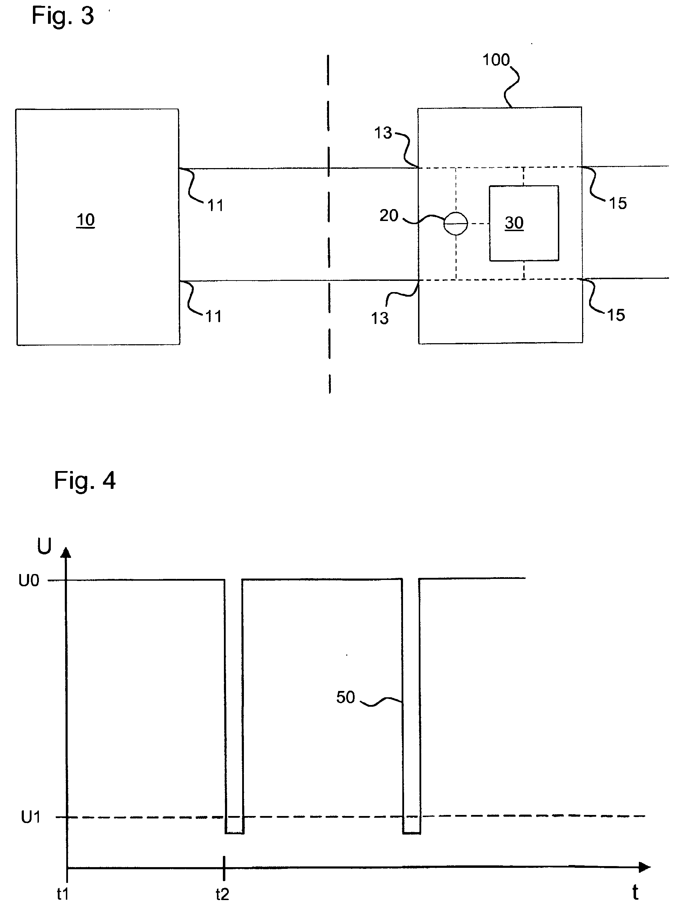

Dieses Problem wird durch ein erfindungsgemäßes Interfacegerät 100 überwunden, welches schematisch zusammen mit einem Leitsystem 10 in Fig. 3 gezeigt ist. Das Interfacegerät 100 umfasst erste Anschlussmittel 13, die mit dem Ausgang 11 des Leitsystems 10 verbunden werden können. Zudem verfügt das Interfacegerät 100 über zweite Anschlussmittel 15, an welche ein Feldgerät oder ein anderes Interfacegerät, welches vom erfindungsgemäßen Interfacegerät 100 verschieden ist, angeschlossen werden können.

Das Interfacegerät 100 umfasst Spannungsbeeinflussungsmittel 20 und elektronische Analyse- und Steuermittel 30. Die Analyse- und Steuermittel 30 erfassen eine Spannung und/oder einen Strom am Ausgang 11. Anhand vorgegebener Kriterien können die Analyse- und Steuermittel 30 aus dem erfassten Strom und/oder der erfassten Spannung ein Testsignal erkennen, welches von der Diagnoseeinrichtung am Ausgang 11 ausgegeben wird.

Sobald die Analyse- und Steuermittel 30 ein Testsignal erkennen, steuern sie die ansteuerbare Stromquelle 20 an, so dass diese einen Strom erzeugt, der zwischen den beiden Anschlussleitungen des Ausgangs 11 fließt. Dadurch können ein Strom und eine Spannung am Ausgang 11 eingestellt werden. In dieser Weise bewirken die Analyse- und Steuermittel, dass eine bestimmte Sollspannung und/oder ein bestimmter Sollstrom am Ausgang 11 erreicht wird. Die Sollspannung oder der Sollstrom sind so vorgegeben, dass sie innerhalb eines Erwartungsbereichs der Diagnoseeinrichtung liegen.

Damit kann vermieden werden, dass ein Fehlersignal ausgegeben wird, obwohl ein funktionstüchtiges Feldgerät angeschlossen ist. Vorteilhafterweise können Sollspannungen und/oder -Ströme für prinzipiell beliebige Arten von Testsignalen eingestellt werden.

Die Analyse- und Steuermittel 30 können auch für verschiedene Arten von Testsignalen unterschiedliche Sollspannungen und/oder -ströme vorsehen. Die Stromquelle 20 wird dann abhängig von der erkannten Art des Testsignals in verschiedener Weise angesteuert.

Ein Strom, der von der Stromquelle 20 bereitgestellt wird, fließt in einem Schaltungspfad, der parallel zu einem an die zweiten Anschlussmittel 15 anschließbaren Feldgerät angeordnet ist. Es kann vorgesehen sein, dass die Analyse- und Steuermittel 30 erkennen, ob ein Feldgerät an dem zweiten Anschlussmittel 15 angeschlossen und ausgeschaltet ist, und dass die Analyse- und Steuermittel 30 nur in diesem Fall die Stromquelle 20 ansteuern.

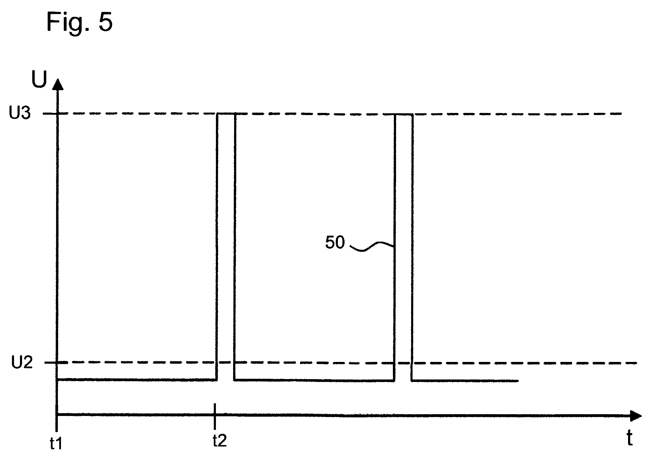

Ein Testsignal 50 eines dynamischen Tests einer Diagnoseeinrichtung eines Leitsystems ist jeweils in den Figuren 4 und 5 gezeigt. Diese zeigen jeweils einen Graphen, in dem eine Spannung U am Ausgang des Leitsystems gegen die Zeit t aufgetragen ist.

Fig. 4 zeigt Testsignale für einen eingeschalteten Zustand, in welchem am Ausgang des Leitsystems, insbesondere zum Zeitpunkt t1, eine Versorgungsspannung U0 ausgegeben wird. Diese kann der Energieversorgung eines angeschlossenen Feldgeräts dienen und beispielsweise 24 V betragen.

Zum Zeitpunkt t2 wird ein Testsignal am Ausgang ausgegeben. Hierzu wird der Ausgang des Leitsystems für kurze Zeit hochohmig geschaltet. Darauf fällt die Spannung am Ausgang ab. Dieser Spannungsabfall wird von der Diagnoseeinrichtung bewertet. Der Spannungsenrvartungsbereich, der für ein ordnungsgemäßes Feldgerät erwartet wird, ist nach oben durch eine Spannungsgrenze U1 beschränkt. Fällt die Spannung innerhalb einer bestimmten Zeit unter die Spannungsgrenze U1, so schließt die Diagnoseeinrichtung auf ein ordnungsgemäßes Feldgerät. Andernfalls gibt sie ein Fehlersignal aus.

Im Beispiel von Fig. 4 ist ein etwa vertikaler, das heißt sofortiger, Abfall der Spannung unter die Spannungsgrenze U1 dargestellt. Dieser Spannungsabfall erfordert aber immer eine gewisse Zeit. Ist innerhalb einer vorgegebenen Zeitdauer ab dem Beginn des Testsignals noch kein Abfall unter die Spannungsgrenze U1 erfolgt, so wird ein Fehlersignal ausgegeben.

Wie in Fig. 4 dargestellt, wird auf das Testsignal der Zeit t2 nach einer vorgegebenen Zeitspanne ein weiteres Testsignal ausgegeben. Beispielsweise kann jeweils nach 500 Millisekunden ein Testsignal ausgegeben werden, für welches der Ausgang zwischen niederohmig und hochohmig für 200 Mikrosekunden umgeschaltet wird.

Fig. 5 zeigt eine Situation, bei der ein Testsignal eines dynamischen Tests ausgegeben wird, wenn ein ausgeschalteter Zustand vorliegt. Hier liegt zum Zeitpunkt t1 also nicht die Versorgungsspannung U0 am Ausgang an, sondern eine Spannung, die unterhalb einer Spannungsgrenze U2 liegt und insbesondere 0 V betragen kann.

Zum Zeitpunkt t2 wird ein Testsignal erzeugt. Dazu wird der Ausgang für kurze Zeit aktiviert oder niederohmig geschaltet und sodann hochohmig geschaltet. Indem der Ausgang niederohmig geschaltet wird, steigt die Spannung am Ausgang innerhalb kurzer Zeit auf einen Wert im Bereich der Versorgungsspannung U0. Wird der Ausgang wieder hochohmig geschaltet, fällt die Spannung am Ausgang wieder innerhalb kurzer Zeit.

Für den Test der Diagnoseeinrichtung sollen zwei Spannungsgrenzen überschritten werden. Innerhalb einer vorbestimmten Zeitdauer ab Aktivierung des Ausgangs, beispielsweise innerhalb von 100 µs, soll eine Spannungsgrenze U3 übertroffen werden. Diese ist im Bereich der Versorgungsspannung U0 vorgegeben. Außerdem soll innerhalb einer vorbestimmten Zeitdauer, nachdem der Ausgang wieder hochohmig geschaltet worden ist, die Spannung unter die Spannungsgrenze U2 sinken.

Wird mindestens eine dieser Bedingungen nicht erfüllt oder werden beide Bedingungen nicht erfüllt, so wird ein Fehlersignal von der Diagnoseeinrichtung ausgegeben.

Die Analyse- und Steuermittel 30 erfassen eine Spannungsänderung oder eine Stromänderung am Ausgang 11, welche durch ein Testsignal hervorgerufen werden. Hierfür wird beispielsweise bloß 15 µs benötigt. Daraufhin wird die Stromquelle 20 so angesteuert, dass in sehr kurzer Zeit, insbesondere innerhalb von 100 µs, ein gewünschter Spannungswert, der über U3 oder unter U2 liegt, eingestellt wird. Somit kann erreicht werden, dass kein Fehlersignal fälschlicherweise ausgegeben wird.

Während der Testpulse der dynamischen Tests, die in den Fig. 4 und 5 dargestellt sind, kann gleichzeitig auch ein Teststrom eines statischen Tests ausgegeben werden. Die erfindungsgemäße Schaltungsanordnung kann für beide Tests gleichzeitig geeignete Spannungs- und Stromwerte am Ausgang erzeugen.

Ein wichtiger Vorteil der Stromquelle liegt in der besonders kurzen Zeit, die für eine Spannungsänderung am Ausgang benötigt wird. Dabei können unterschiedlich hohe und lange Ströme erzeugt werden, so dass für verschiedene Tests eine Kompatibilität erreicht wird. Schließlich sind auch Energieverluste im Vergleich zu herkömmlichen Schaltungsanordnungen gering.

## Patentansprüche

1. Verfahren zur Kompatibilitätsherstellung zwischen einem Feldgerät oder einem Interfacegerät für ein Feldgerät und einer Diagnoseeinrichtung eines Leitsystems (10), an dessen Ausgang (11) das Interface- oder Feldgerät angeschlossen ist,
bei dem die Diagnoseeinrichtung über den Ausgang (11) des Leitsystems (10) ein Testsignal (50) an das Interface- oder Feldgerät gibt und ein Fehlersignal ausgibt, wenn eine elektrische Antwort am Ausgang (11) des Leitsystems (10) außerhalb eines Erwartungsbereichs liegt, und
bei dem mit Spannungsbeeinflussungsmittel (20) eine Spannung am Ausgang (11) des Leitsystems (10) beeinflusst wird,
bei dem die Spannungsbeeinflussungsmittel (20) eine ansteuerbare Stromquelle (20) aufweisen,
bei dem ein Testsignal (50) der Diagnoseeinrichtung am Ausgang (11) des Leitsystems (10) von elektronischen Analyse- und Steuermitteln (30) identifiziert wird,
bei dem bei einer Identifizierung eines Testsignals (50) die ansteuerbare Stromquelle (20) von den Analyse- und Steuermitteln (30) dazu angesteuert wird, eine Sollspannung am Ausgang (11) des Leitsystems (10) einzustellen,
wobei bei einem funktionstücktigen Feldgerät die angesteuerte Sollspannung innerhalb des Erwartungsbereichs der Diagnoseeinrichtung liegt.

2. Interfacegerät zum Verbinden eines Leitsystems (10) mit einem Feldgerät oder mit einem anderen Interfacegerät eines Feldgeräts,
wobei das Interfacegerät erste Anschlussmittel (13) umfasst zum Herstellen einer elektrischen Verbindung mit dem Leitsystem (10) und zum Empfangen eines von einer Diagnoseeinrichtung des Leitsystems (10) ausgegebenen Testsignals (50), wobei das Interfacegerät zweite Anschlussmittel (15) zum Herstellen einer elektrischen Verbindung mit dem Feldgerät oder dem anderen Interfacegerät umfasst,
wobei das Interfacegerät eine Schaltungsanordnung zur Kompatibilitätsherstellung zwischen dem Feldgerät oder dem anderen Interfacegerät und der Diagnoseeinrichtung des Leitsystems (10) umfasst,
wobei die Schaltungsanordnung Spannungsbeeinflussungsmittel (20) aufweist zum Beeinflussen einer Spannung an einem Ausgang (11) des Leitsystems (10),
wobei die Spannungsbeeinflussungsmittel (20) eine ansteuerbare Stromquelle (20) aufweisen,
wobei die Schaltungsanordnung elektronische Analyse- und Steuermittel (30) aufweist, welche dazu eingerichtet sind,
- ein Testsignal (50) am Ausgang (11) des Leitsystems (10) zu identifizieren und
- bei einer Identifizierung eines Testsignals (50) die ansteuerbare Stromquelle (20) zum Einstellen einer Sollspannung am Ausgang (11) des Leitsystems (10) anzusteuern, wobei bei einem funktionstücktigen Feldgerät die angesteuerte Sollspannung innerhalb des Enwartungsbereichs der Diagnoseeinrichtung liegt.

3. Interfacegerät nach Anspruch 2,
**dadurch gekennzeichnet,**
**dass** mit den elektronischen Analyse- und Steuermitteln (30) zum Identifizieren eines Testsignals (50) eine Messung einer Spannung und/oder eines Stroms am Ausgang (11) des Leitsystems (10) durchführbar ist.

4. Interfacegerät nach Anspruch 2 oder 3,
**dadurch gekennzeichnet,**
**dass** die elektronischen Analyse- und Steuermittel (30) dazu eingerichtet sind, ein Testsignal (50) zu identifizieren basierend auf einer Messung einer Stromstärke, einer Stromstärkenänderung, einer Spannungshöhe und/oder einer Spannungshöhenänderung am Ausgang (11) des Leitsystems (10).

5. Interfacegerät nach Anspruch 3 oder 4,
**dadurch gekennzeichnet,**
**dass** mit den elektronischen Analyse- und Steuermitteln (30) ein Ergebnis der Messung mit vorgegebenen Kriterien bewertbar ist, um zwischen verschiedenen Arten von Testsignalen zu unterscheiden.

6. Interfacegerät nach einem der Ansprüche 2 bis 5,
**dadurch gekennzeichnet,**
**dass** die elektronischen Analyse- und Steuermittel (30) dazu eingerichtet sind, für verschiedene Arten von Testsignalen eine Höhe und/oder Dauer eines von der Stromquelle (20) erzeugten Stroms unterschiedlich einzustellen.

7. Interfacegerät nach Anspruch 5 oder 6,
**dadurch gekennzeichnet,**
**dass** die elektronischen Analyse- und Steuermittel (30) dazu eingerichtet sind, mit den vorgegebenen Kriterien mehrere gleichzeitige Testsignale unterschiedlicher Art zu erkennen und die Stromquelle (20) abhängig von gleichzeitig erkannten Testsignalen anzusteuern.

8. Interfacegerät nach einem der Ansprüche 2 bis 7,
**dadurch gekennzeichnet,**
**dass** Kriterien der elektronischen Analyse- und Steuermittel (30) zum Identifizieren eines Testsignals (50) variabel einstellbar sind.

9. Interfacegerät nach Anspruch 8,
**dadurch gekennzeichnet,**
**dass** die elektronischen Analyse- und Steuermittel (30) einen Mikrocontroller aufweisen, mit dem Kriterien zum Identifizieren eines Testsignals (50) variabel einstellbar sind und eine Höhe und/oder Dauer eines von der Stromquelle (20) erzeugten Stroms variabel einstellbar sind.

10. Interfacegerät nach einem der Ansprüche 2 bis 9,
**dadurch gekennzeichnet,**
**dass** die elektronischen Analyse- und Steuermittel (30) dazu eingerichtet sind, einen ausgeschalteten Zustand eines angeschlossenen Feldgeräts zu identifizieren und, wenn ein ausgeschalteter Zustand identifiziert ist, die ansteuerbare Stromquelle (20) zum Einstellen der Sollspannung und/oder zum Erzeugen eines Stroms vorgegebener Höhe anzusteuern.

11. Interfacegerät nach einem der Ansprüche 2 bis 10,
**dadurch gekennzeichnet,**
**dass** die elektronischen Analyse- und Steuermittel (30) dazu eingerichtet sind, ihren Energiebedarf zum Steuern der ansteuerbaren Stromquelle (20) aus Strompulsen von Testsignalen zu decken.

## Claims

1. A method for establishing compatibility between a field device or an interface device for a field device and a diagnostic system pertaining to a control system (10), to the output (11) of which said interface device or field device is connected,
in which said diagnostic system sends a test signal (50) to said interface device or field device via said output (11) of said control system (10) and emits an error signal when an electrical response at the output (11) of said control system (10) is outside an expectancy range, and
with which a voltage at said output (11) of said control system (10) is influenced by means of a voltage influencing means (20),
said voltage influencing means (20) comprising a controllable current source (20),
wherein a test signal (50) of said diagnostic system at said output (11) of said control system (10) is identified by electronic analyzing and controlling means (30),
wherein, on identification of a test signal (50), said controllable current source (20) is driven by said analyzing and controlling means (30) to set a target voltage at said output (11) of said control system (10), wherein, at a properly functioning field device, said controlled target voltage is within the expectancy range of said diagnostic system.

2. An interface device for connecting a control system (10) to a field device or to another interface device of a field device,
said interface device comprising first connecting means (13) for the establishment of an electrical connection with said control system (10) and for receiving a test signal (50) output from a diagnose system of said control system (10), said interface device comprising second connecting means (15) for the establishment of an electrical connection to said field device or said other interface device,
said interface device comprising a circuit arrangement for establishing compatibility between said field device or said other interface device and said diagnostic system of said control system (10),
wherein said circuit arrangement comprises a voltage influencing means (20) for influencing a voltage at an output (11) of said control system (10),
wherein said voltage influencing means (20) comprises a controllable current source (20),
wherein said circuit arrangement comprises electronic analyzing and controlling means (30) which are adapted
- to identify a test signal (50) at said output (11) of said control system (10) and,
- on identification of a test signal (50), to instruct said controllable current source (20) to adjust a target voltage at said output (11) of said control system (10), wherein, at a properly functioning field device, said controlled target voltage is within the expectancy range of said diagnostic system.

3. The interface device as defined in claim 2,
**characterized in that**
said electronic analyzing and controlling means (30) are capable of carrying out a measurement of a voltage and/or of a current at the output (11) of said control system (10) for the purpose of identifying a test signal (50).

4. The interface device as defined in claim 2 or claim 3,
**characterized in that**
said electronic analyzing and controlling means (30) are adapted to identify a test signal (50) based on a measurement of a current intensity, a change in current intensity, a voltage level and/or a change in voltage level at said output (11) of said control system (10).

5. The interface device as defined in claim 3 or claim 4,
**characterized in that**
said electronic analyzing and controlling means (30) are capable of evaluating a result of said measurement by implementation of predetermined criteria, in order to differentiate between various types of test signal.

6. The interface device as defined in any one of claims 2 to 5, **characterized in that**
said electronic analyzing and controlling means (30) are adapted to set the intensity and/or duration of a current generated by said current source (20) at different values for various types of test signal.

7. The interface device as defined in claim 5 or claim 6,
**characterized in that**
said electronic analyzing and controlling means (30) are adapted to recognize, using said specified criteria, a plurality of simultaneous test signals of different types and to instruct said current source (20) in accordance with said simultaneously recognized test signals.

8. The interface device as defined in any one of claims 2 to 7, **characterized in that**
said criteria of said electronic analyzing and controlling means (30) can be set variably for the purpose of identifying a test signal (50).

9. The interface device as defined in claim 8,
**characterized in that**
said electronic analyzing and controlling means (30) comprise a microcontroller, by means of which criteria for identifying a test signal (50) can be set variably and an intensity and/or duration of a current generated by said current source (20) can be set variably.

10. The interface device as defined in any one of claims 2 to 9, **characterized in that**
said electronic analyzing and controlling means (30) are adapted to identify a switched-off state of a connected field device and, when a switched-off state is identified, to instruct said controllable current source (20) to adjust the target voltage and/or to generate a current of specified intensity.

11. The interface device as defined in any one of claims 2 to 10, **characterized in that**
said electronic analyzing and controlling means (30) are adapted to obtain their energy requirements for issuing instructions to said controllable current source (20) from current impulses of test signals.

## Revendications

1. Procédé pour l'établissement d'une compatibilité entre un appareil de terrain, ou un appareil d'interface pour un appareil de terrain, et un dispositif de diagnostic d'un système de commande (10), à la sortie (11) duquel l'appareil d'interface ou de terrain est connecté,
selon lequel le dispositif de diagnostic fournit un signal de test (50) à l'appareil d'interface ou de terrain, par l'intermédiaire de la sortie (11) du système de commande (10), et délivre un signal d'erreur si une réponse électrique sur la sortie (11) du système de commande (10) se situe à l'extérieur d'une plage attendue, et selon lequel on agit sur une tension sur la sortie (11) du système de commande (10), à l'aide de moyens (20) destinés à agir sur une tension,
selon lequel les moyens (20) destinés à agir sur une tension comprennent une source de courant pouvant être commandée (20),
selon lequel un signal de test (50) du dispositif de diagnostic est identifié sur la sortie (11) du système de commande (10) par des moyens électroniques d'analyse et de commande (30),
selon lequel, dans le cas d'une identification d'un signal de test (50), la source de courant pouvant être commandée (20) est commandée par les moyens d'analyse et de commande (30) de manière à régler sur la sortie (11) du système de commande (10) une tension cible, la tension cible ainsi commandée se situant, dans le cas d'un appareil de terrain opérationnel, à l'intérieur de la plage attendue du dispositif de diagnostic.

2. Appareil d'interface destiné à relier un système de commande (10) à un appareil de terrain ou à un autre appareil d'interface d'un appareil de terrain,
dans lequel l'appareil d'interface comprend des premiers moyens de connexion (13) pour l'établissement d'une liaison électrique avec le système de commande (10) et pour la réception d'un signal de test (50) délivré par un dispositif de diagnostic du système de commande (10),
dans lequel l'appareil d'interface comprend des deuxièmes moyens de connexion (15) pour l'établissement d'une liaison électrique avec l'appareil de terrain ou avec l'autre appareil d'interface,
dans lequel l'appareil d'interface comprend un agencement de circuit pour l'établissement d'une compatibilité entre l'appareil de terrain, ou l'autre appareil d'interface, et le dispositif de diagnostic du système de commande (10),
dans lequel l'agencement de circuit comprend des moyens (20) destinés à agir sur une tension, pour agir sur une tension sur une sortie (11) du système de commande (10),
dans lequel les moyens (20) destinés à agir sur une tension comprennent une source de courant pouvant être commandée (20),
dans lequel l'agencement de circuit comprend des moyens électroniques d'analyse et de commande (30), configurés :
- pour identifier un signal de test (50) sur la sortie (11) du système de commande (10), et,
- dans le cas d'une identification d'un signal de test (50), pour commander la source de courant pouvant être commandée (20), afin de régler une tension cible sur la sortie (11) du système de commande (10), la tension cible ainsi commandée se situant, dans le cas d'un appareil de terrain opérationnel, à l'intérieur de la plage attendue du dispositif de diagnostic.

3. Appareil d'interface selon la revendication 2,
**caractérisé :**
**en ce qu'**une mesure d'une tension et/ou d'un courant peut être effectuée sur la sortie (11) du système de commande (10) avec les moyens électroniques d'analyse et de commande (30), pour l'identification d'un signal de test (50).

4. Appareil d'interface selon la revendication 2 ou 3,
**caractérisé :**
**en ce que** les moyens électroniques d'analyse et de commande (30) sont organisés pour identifier un signal de test (50) en se basant sur une mesure d'une intensité de courant, d'une modification d'une intensité de courant, d'une amplitude de tension et/ou d'une modification d'une amplitude de tension sur la sortie (11) du système de commande (10).

5. Appareil d'interface selon la revendication 3 ou 4,
**caractérisé :**
**en ce qu'**à l'aide des moyens électroniques d'analyse et de commande (30), un résultat de la mesure peut être évalué selon des critères prédéfinis, pour opérer une distinction entre différents types de signaux de test.

6. Appareil d'interface selon une des revendications 2 à 5,
**caractérisé :**
**en ce que** les moyens électroniques d'analyse et de commande (30) sont organisés pour régler de manière différente, pour différents types de signaux de test, une amplitude et/ou une durée d'un courant généré par la source de courant (20).

7. Appareil d'interface selon la revendication 5 ou 6,
**caractérisé :**
**en ce que** les moyens électroniques d'analyse et de commande (30) sont organisés pour reconnaître, à l'aide des critères prédéfinis, plusieurs signaux de test simultanés de type différent et pour commander la source de courant (20) en fonction de signaux de test simultanés reconnus.

8. Appareil d'interface selon une des revendications 2 à 7,
**caractérisé :**
**en ce que** les critères des moyens électroniques d'analyse et de commande (30) pour l'identification d'un signal de test (50) peuvent être réglés de manière variable.

9. Appareil d'interface selon la revendication 8,
**caractérisé :**
**en ce que** les moyens électroniques d'analyse et de commande (30) comprennent un microcontrôleur, avec lequel les critères pour l'identification d'un signal de test (50) peuvent être réglés de manière variable et une amplitude et/ou une durée d'un courant généré par la source de courant (20) peut(peuvent) être réglée(s) de manière variable.

10. Appareil d'interface selon une des revendications 2 à 9,
**caractérisé :**
**en ce que** les moyens électroniques d'analyse et de commande (30) sont organisés pour l'identification d'un état désactivé d'un appareil de terrain connecté, et, si un état désactivé est identifié, pour commander la source de courant pouvant être commandée (20), afin de régler la tension cible et/ou pour générer un courant d'une amplitude prédéfinie.

11. Appareil d'interface selon une des revendications 2 à 10, **caractérisé :**
**en ce que** les moyens électroniques d'analyse et de commande (30) sont organisés pour couvrir leurs besoins en énergie en vue de la commande de la source de courant pouvant être commandée (20) à partir d'impulsions de courant provenant de signaux de test.
